# EUROPEAN PATENT APPLICATION

(11) **EP 3 181 729 A1**
(43) Date of publication of application: **21.06.2017**
(21) Application number: 16002627.4
(22) Date of filing: 09.12.2016
(51) Int. Cl.: C23C 30/00, C23C 28/04, C23C 28/00, C23C 14/06

(54) **HARD COATING AND DIE**

(30) Priority: 15.12.2015 JP 2015243952
(71) Applicant: Kabushiki Kaisha Kobe Seiko Sho (Kobe Steel, Ltd.), Kobe-shi, Hyogo 651-8585 (JP)
(72) Inventor: Yamamoto, Kenji, Kobe-shi, Hyogo 651-2271 (JP); Miura, Katsutomo, Aichi 489-0071 (JP); Nishibu, Atsushi, Aichi 489-0071 (JP)
(74) Representative: Müller-Boré & Partner Patentanwälte PartG mbB

(57) **Abstract**

To provide a hard coating having an excellent wear resistance and a die having the hard coating formed on the surface.

The hard coating contains at least each of chromium (Cr), an element M and carbon (C). The element M comprises elements belonging to the group 4a of the periodic table, elements belonging to the group 5a of the periodic table, and elements belonging to the group 6a of the periodic table except for Cr, and at least one element selected from the group consisting of aluminum (Al), silicon (Si), and boron (B). The atomic ratio of C in the hard coating is 0.03 or more and 0.5 or less.

## Description

The present invention relates to a hard coating and a die.

In recent years, dies used, for example, in press-forming of metal sheets are used in higher loading state compared with existent cases since they are used for forming metal sheets of high strength such as high tensile strength steel sheets or used in new fabrication methods such as hot pressing (hot stamping). Accordingly, wear amount of the dies caused by press-forming of metal sheets has been increased more remarkably at present.

In order to cope with such a situation, it has been proposed to prevent the die from wear by press-forming by forming a coating comprising a hard metal as a wear resistant layer on a forming surface of a die that presses the metal sheet. For example, the following patent literature 1 (JP-A 2012-1801) discloses that a chromium (Cr) type hard coating is formed by a physical vapor deposition (PVD) method to the surface of the die.

In the die having the Cr type hard coating formed on the surface as disclosed in the patent literature 1, while wear of the die caused by press-forming can be prevented to some extent, the effect thereof was not sufficient. Accordingly, it was necessary to further improve the wear resistance of the hard coating formed on the forming surface of the die in order to provide a die capable of coping with press-forming applied in the higher load state as in recent years.

The present invention has been achieved in view of the subject described above and intends to provide a hard coating having an excellent wear resistance and a die having the hard coating formed on the surface.
(1) The hard coating according to an aspect of the present invention is a hard coating containing at least each of elements Cr, M, and C. The element M comprises elements belonging to the group 4a of the periodic table, elements belonging to the group 5a of the periodic table, elements belonging to the group 6a of the periodic table except for Cr, and at least one element selected from the group consisting of Al, Si, and B. The atomic ratio of C in the hard coating is 0.03 or more and 0.5 or less.
   The present inventors have made an earnest study on chemical components in the coating in order to improve the wear resistance of Cr-type hard coatings such as chromium carbide (CrC) coating or a chromium carbonitride (CrCN) coating. As a result, the present inventors have found that the wear resistance of the Cr type coating is improved remarkably by adding a specific element M and defining the amount of carbon (C) introduced in the coating to a predetermined range in the Cr-type hard coating and have attained the present invention.
   In the hard coating, a specific element M comprising elements belonging to the group 4a, elements belonging to the group 5a, elements belonging to the group 6a of the periodic table (except for Cr), and at least one element selected from the group consisting of Al, Si and B added in the Cr type hard coating. Accordingly, in the hard coating described above, the wear resistance is remarkably improved compared with the existent Cr-type hard coatings with no addition of the element M. Further, the element M is preferably an element binding to C to form carbides and preferably contains W (group 6a), Mo (group 6a), Ti (group 4a) or V (group 5a).
   Further, as a result of a detailed study made by the present inventors, it has been found that the amount of C to be introduced also gives a significant effect on the wear resistance of the coating. Specifically, when the atomic ratio of C is less than 0.03 or more than 0.5, the wear resistance of the coating is deteriorated, whereas the wear resistance is improved greatly by defining the atomic ratio within a range of 0.03 or more and 0.5 or less. The hard coating has a remarkably improved wear resistance by the introduction of C such that the atomic ratio is 0.03 or more and 0.5 or less. Further, with a view point of further improving the wear resistance, the atomic ratio of C is preferably less than 0.3, more preferably, 0.05 or more and, further preferably, 0.1 or more.
   Each of the elements contained in the hard coating can be detected by EDX (energy dispersion X-ray spectrophotometry). Specifically, by irradiating the surface of the coating with electron beams and detecting characteristic X-rays inherent to each element generated thereby, it is possible to confirm that each of the elements Cr, M, and C is present in the coating and confirm that the atomic ratio of C is within a range of 0.03 or more and 0.5 or less by quantitative analysis.
(2) The hard coating may be a mono-layered coating having a compositional formula: Cr_{1-a-b-c-d} MₐC_{b}N_{c}X_{d}. The element X is at least one element selected from the group consisting of Fe, Ni, Co, and Cu. In the compositional formula, a, b, c, and d each represent the atomic ratio of M, C, N, and X respectively. Further, in the compositional formula, relations: 0.01 ≤ a ≤ 0.2 and 0.03 ≤ b ≤ 0.5 may also be satisfied.
   As a result of a detailed study made by the present inventors, the wear resistance of the coating is further improved by introducing the element M such that the atomic ratio a is 0.01 or more and, on the other hand, if the atomic ratio exceeds 0.2, the wear resistance is deteriorated on the contrary. Accordingly, the wear resistance of the coating can be improved more by introducing the element M such that the atomic ratio a is 0.01 or more and 0.2 or less. The atomic ratio a of the element M is preferably 0.1 or less and, more preferably, 0.05 or less.
   When a mono-layered coating satisfying the compositional formula described above is used, it is not necessary to provide a plurality of kinds of targets and depositing them during coating deposition by a PVD process or the like, different from the case of laminating a plurality of coatings comprising compositional formulae different from each other, and the coating can be deposited by a simpler process.
(3) In the hard coating, a relation: 0 ≤ c ≤ 0.2 may also be satisfied.
   If nitrogen (N) is introduced till the atomic ratio c exceeds 0.2, since the amount of carbides in the coating is decreased, the wear resistance is deteriorated. Accordingly, N is preferably introduced such that the atomic ratio c is 0.2 or less, or N may not be introduced (c = 0).
(4) In the hard coating, a relation: 0 ≤ d ≤ 0.05 may also be satisfied.
   The wear resistance of the coating can be improved more by adding the element X (Fe, Ni, Co, Cu) in the coating. However, if the element X is added excessively till the atomic ratio d exceeds 0.05, the wear resistance is deteriorated on the contrary by the softening of the coating. Therefore, the element X is preferably introduced such that the atomic ratio d is 0.05 or less and, introduced more preferably such that the ratio is 0.03 or less and, introduced further preferably such that the ratio is 0.01 or less. Further, the element X may not be introduced (d = 0).
(5) The hard coating may be a multi-layered coating comprising a first coating layer and a second coating layer laminated alternately. The first coating layer may have a compositional formula: Cr_{1-e-f-g} MₑC_{f}N_{g}. In the compositional formula, e, f, and g each represent the atomic ratio of each of M, C, and N respectively. Further, in the compositional formula, relations: 0.03 ≤ f ≤ 0.5 and 1-e-f-g > e may also be satisfied. The second coating layer may have a compositional formula: M₁₋ₕ₋ᵢ₋ⱼ₋ₖ CrₕCᵢNⱼXₖ. The element X is at least one element selected from the group consisting of Fe, Ni, Co, and Cu. In the compositional formula, h, i, j, and k each represent atomic ratio of Cr, C, N, and X respectively. Further, in the compositional formula, relations: 0.03 ≤ i ≤ 0.5 and 1-h-i-j-k > h may also be satisfied.
   Also in the multi-layered coating formed by alternately laminating a first coating layer with addition of more Cr than the element M (1-e-f-g > e) and a second coating layer with addition of more element M than Cr (1-h-i-j-k > h), the wear resistance can be improved by introducing the element M and defining the atomic ratios f and i of C within a range of 0.03 or more and 0.5 or less in the same manner as in the mono-layered coating into which Cr and the element M are introduced.
   In the first coating layer, the element M may be introduced such that the atomic ratio e is 0 or more and 0.2 or less. Further, in the second coating layer, Cr may be introduced such that the atomic ratio h is 0 or more and 0.2 or less.
   With a view point of obtaining a sufficient effect as the multi-layered coating, the thickness of each of the first and the second coating layers is preferably 100 nm or less, more preferably, 20 nm or less and, further preferably, 10 nm or less.
   The structure of the multi-layered coating can be confirmed by an observation method such as by a cross sectional TEM (transmission electron microscope). Further, the multi-layered coating can also be analyzed quantitatively in the same manner as in the case of the mono-layered coating, and it can be confirmed that each of the elements is present in the coating and each of the atomic ratios is within the range described above by EDX.
(6) In the hard coating, the first coating layer may satisfy the relation: 0 ≤ g ≤ 0.2. Further, the second coating layer may satisfy the relation: 0 ≤ j ≤ 0.2.
   In the first and the second coating layers, if N is introduced till the atomic ratios g and j exceed 0.2, the amount of carbides in the coating is decreased to deteriorate the wear resistance. Therefore, N is preferably introduced such that the atomic ratios g and j are 0.2 or less.
(7) In the hard coating layer, a relation; 0 ≤ k ≤ 0.05 may also be satisfied.
   The wear resistance of the coating can be improved more by adding the element X (Fe, Ni, Co, Cu) in the second coating layer. However, if the element X is added excessively such that the atomic ratio k exceeds 0.05, the wear resistance is deteriorated on the contrary by the softening of the coating. Accordingly, the element X is preferably introduced such that the atomic ratio k is 0.05 or less, introduced more preferably such that the ratio k is 0.03 or less and, introduced further preferably such that the ratio k is 0.01 or less. Further, the element X may not be introduced (k = 0).
(8) In the hard coating, the thickness of the first coating layer may be larger than the thickness of the second coating layer.
   As described above, by making the thickness of the first coating layer with more addition amount of Cr larger than the thickness of the second coating layer with more addition amount of the element M, the amount of the introduced element M does not increase excessively in the entire coating and the wear resistance can be improved more.
   The thickness of the first coating layer is preferably twice or larger than that of the second coating layer. However, if the thickness of the first coating layer is excessively larger than that of the second coating layer, since the effect due to the second coating layer is lowered, the wear resistance is deteriorated. Accordingly, the thickness of the first coating layer is preferably not more than 10 times the thickness of the second coating layer and, more preferably, not more than 5 times thereof.
(9) In the hard coating, the element M may be at least one element selected from W and V.
   W and V have a property that the reactivity to iron oxides is low. Accordingly, when a steel sheet is formed by using a die having the hard coating formed on the surface, reaction between the iron oxides formed on the steel sheet and the coating can be suppressed to be thereby capable of improving the wear resistance further. Further, since W has more excellent effect, the element M preferably contains at least W and may contain only W. Further, W and V have a property that hardness is higher in the carbides than in the nitrides thereof. Accordingly, when the element M contains at least one of the elements W and V, it is preferred that N is not added.
(10) A die according to another aspect of the present invention is a die having a forming surface for forming a material to be formed. The hard coating is formed on the forming surface.
   In the die, the hard coating of excellent wear resistance is formed over the forming surface. Therefore, according to the die, even when the die is used in a high load state such as in forming of a high tensile strength steel sheets or hot pressing, wear of the die due to contact with the material to be formed can be suppressed.
(11) The die may also be a die for forming the material to be formed having the metal layer containing Al or Zn formed on the surface.

The hard coating has an excellent wear resistance during sliding movement and also has an excellent adhesion resistance to a soft metal since this is carbide-based coating. Accordingly, upon forming the material to be formed having the metal layer containing soft metal such as Al or Zn formed on the surface, adhesion of the metal layer to the die can be suppressed. Particularly, since adhesion is liable to occur due to contact between the soft metal and the die in the hot pressing, the hard coating is preferably formed on the forming surface of the die. Further, "metal layer containing Al or Zn" includes a metal layer comprising an elemental metal such as Al and Zn, or a metal layer comprising a metal alloy such as Al-Si, Zn-Al, Zn-Mg, and Zn-Fe.

According to the present invention, it is possible to provide a hard coating having an excellent wear resistance and a die having the hard coating formed on the surface thereof.
Fig. 1 is a schematic view illustrating a structure of a die according to a first embodiment of the invention;
Fig. 2 is a schematic view illustrating a hard coating according to the first embodiment of the invention;
Fig. 3 is a schematic view illustrating a configuration of a coating deposition apparatus for depositing the hard coating; and
Fig. 4 is a schematic view illustrating a hard coating according to a second embodiment of the invention.

Preferred embodiments of the invention are to be described specifically below with reference to the drawings.

### First Embodiment

### Die

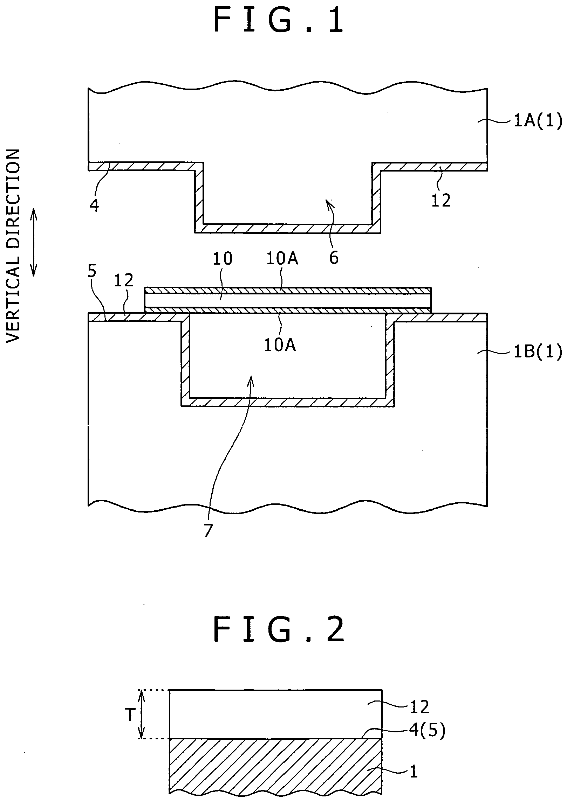

First, the structure of a die 1 according to a first embodiment of the present invention is to be described with reference to Fig. 1. The die 1 is a pressing die for forming a metal sheet 10 (material to be formed), and has an upper die (first die) 1A and a lower die (second die) 1B. The metal sheet 10 is, for example, a steel sheet or an aluminum (Al) sheet in which a metal layer 10A containing Al or zinc (Zn) is formed on the surface thereof. The metal layer 10A is formed by a method, for example, plating and comprises an elemental metal, for example, Al or Zn or a metal alloy, for example, Al-Si, Zn-Al, Zn-Mg, or Zn-Fe. The metal layer 10A may not be formed on the metal sheet. Further, the die 1 is not restricted to the bending die illustrated in Fig. 1 but is applicable also to other pressing dies, for example, punching die, drawing die, or compression die.

As illustrated in Fig. 1, the upper die 1A and the lower die 1B are arranged being spaced from each other in a vertical direction (arrows in Fig. 1). The upper die 1A and the lower die 1B include forming surfaces 4 and 5 in contact with the metal sheet 10 during press forming. A protrusion 6 protruding to the lower die 1B is formed on the forming surface 4 of the upper die 1A, and a recess 7 concaving in the direction opposite to the upper die 1A is formed on the forming surface 5 of the lower die 1B. The protrusion 6 and the recess 7 are formed to a shape and a size that can engage to each other.

The upper die 1A and the lower die 1B are adapted to be movable relatively in the direction approaching to or apart from each other by a driving force from a not illustrated driving source. Specifically, they are adapted such that the lower die 1B is positionally fixed and the upper die 1A is movable in the vertical direction. Then, the metal sheet 10 melted by heating in an electric furnace or by ohmic heating is disposed so as to cover the opening of the recess 7 over the forming surface 5 of the lower die 1B. By lowering the upper die 1A to the lower die 1B while setting the position of the lower die 1B in this state, the metal sheet 10 is pressed by the protrusion 6. This forms the metal sheet 10 into a shape which is bent along the trench form of the recess 7.

When the metal sheet 10 is press-formed as described above, wear of forming surfaces 4 and 5 proceeds on the dies 1A and 1B by the sliding movement in contact with the metal sheet 10 when the metal sheet 10 is press-formed. Particularly, in the hot pressing of press-forming the metal sheet 10 in a hot-molten state, proceeding of such wear is remarkable. In order to prevent such wear of the die, in the dies 1A and 1B according to this embodiment, a hard coating 12 having an excellent wear resistance is formed on the forming surfaces 4 and 5 as the wear resistant layer for suppressing the wear caused by sliding movement with the metal sheet 10. The composition of the hard coating 12 is to be described specifically.

The invention is not restricted to the case of forming the hard coating 12 to both of the upper die 1A and the lower die 1B as illustrated in Fig. 1, but the hard coating 12 may be formed to only one of them. Further, the invention is not restricted only to the case where the hard coating 12 is formed entirely over the forming surfaces 4 and 5 as illustrated in Fig. 1, but the hard coating 12 may also be formed only to a portion where the wear proceeds particularly remarkably.

### Hard Coating

As illustrated in Fig. 2, the hard coating 12 is coated thinly and uniformly over the forming surfaces 4 and 5 of the die 1. The hard coating 12 is formed by a physical vapor deposition (PVD) method such as an ion plating or sputtering method and it is particularly preferred that the hard coating 12 is formed by an arc ion plating (AIP) method. However, the coating deposition method is not restricted only thereto but, for example, a chemical vapor deposition (CVD) method may also be used. The thickness T of the hard coating 12 is about 5 µm. The deposition process of the hard coating 12 is to be described specifically later.

The hard coating 12 contains at least each of elements Cr, M and C and comprises a mono-layered coating having a compositional formula: Cr_{1-a-b-c-d} MₐC_{b}N_{c}X_{d}. The element M comprises elements belonging to the group 4a of the periodic table (Ti, Zr, Hf, etc.), elements belonging to the group 5a of the periodic table (V, Nb, Ta, etc.), elements belonging to the group 6a of the periodic table except for Cr (Mo, W, etc.), and at least one element selected from the group consisting of Al, Si and B. The element X is at least one element selected from the group consisting of Fe, Ni, Co, and Cu. In the compositional formula, a stands for the atomic ratio of the element M, b stands for the atomic ratio of C, c stands for the atomic ratio of N, and d stands for the atomic ratio of the element X. Since the total of atomic ratios for Cr, the elements M, C, N and the element X is 1, the atomic ratio of Cr is represented by 1-a-b-c-d. As described above, the wear resistance of the hard coating 12 according to this embodiment is greatly improved by adding the predetermined element M to the CrC coating or the CrCN coating.

The element M may also be a kind of element selected from the groups described above, or may be a plurality of kinds of elements. Further, the element M preferably includes elements binding to C in the coating to form carbides and preferably includes W, Mo, Ti or V.

Further, the element M is preferably at least one kind of elements selected from W and V (one or both of W and V) by the following reasons. W and V have a property that the reactivity to iron oxides is low. Accordingly, when a steel sheet is formed by using the die 1 having the hard coating 12 formed over the forming surfaces 4 and 5, reaction between the iron oxides formed on the surface of the steel sheet and the hard coating 12 can be suppressed to further improve the wear resistance of the hard coating 12. Further, W and V have a property that their nitrides have higher hardness than their carbides. Accordingly, when the element M contains at least one of elements W and V as described above, it is preferred that N is not added (c = 0) to the hard coating 12.

The element M is introduced into the hard coating 12 such that the atomic ratio a is 0.01 or more and 0.2 or less (0.01 ≤ a ≤ 0.2). The wear resistance of the hard coating 12 is greatly improved by introducing the element M such that the atomic ratio a is 0.01 or more compared with the case where the ratio is less than 0.01. On the other hand, if the atomic ratio a is more than 0.2, the wear resistance of the hard coating 12 is deteriorated on the contrary. Accordingly, the element M is introduced such that the atomic ratio a is within a range of 0.01 or more and 0.2 or less. Further, the element M is preferably introduced such that the atomic ratio a is 0.1 or less and more preferably introduced such that the atomic ratio a is 0.05 or less.

C is introduced into the hard coating 12 such that the atomic ratio b is 0.03 or more and 0.5 or less (0.03 ≤ b ≤ 0.5). The wear resistance of the coating is deteriorated if the atomic ratio b is less than 0.03 and if it is more than 0.5. On the contrary, in the hard coating 12 according to this embodiment, a high wear resistance is attained by containing the predetermined element M and, in addition, by introducing C such that the atomic ratio b is within the range of 0.03 or more and 0.5 or less. C may also be introduced such that the atomic ratio b is less than 0.3 for further improving the wear resistance and, C may also be introduced such that the atomic ratio b is 0.05 or more or C may be introduced such that the atomic ratio b is 0.1 or more.

N is introduced into the hard coating 12 such that the atomic ratio c is 0 or more and 0.2 or less (0 ≤ c ≤ 0.2). If it is introduced such that the atomic ratio c exceeds 0.2, the wear resistance is deteriorated since the amount of carbides in the coating is decreased. Accordingly, N is introduced within a range that the atomic ratio c is 0.2 or less, or N may not be introduced (c = 0).

The element X is introduced into the hard coating 12 such that the atomic ratio d is 0.05 or less (0 ≤ d ≤ 0.05). While the wear resistance can be improved more by adding the element X (Fe, Ni, Co, Cu) to the hard coating 12, if the element X is added excessively till the atomic ratio d exceeds 0.05, the wear resistance is deteriorated on the contrary since the coating is softened. Accordingly, the element X is preferably introduced such that the atomic ratio d is 0.05 or less, introduced more preferably such that the atomic ratio d is 0.03 or less and introduced further preferably such that the atomic ratio is 0.01 or less.

### Deposition Process of Hard Coating

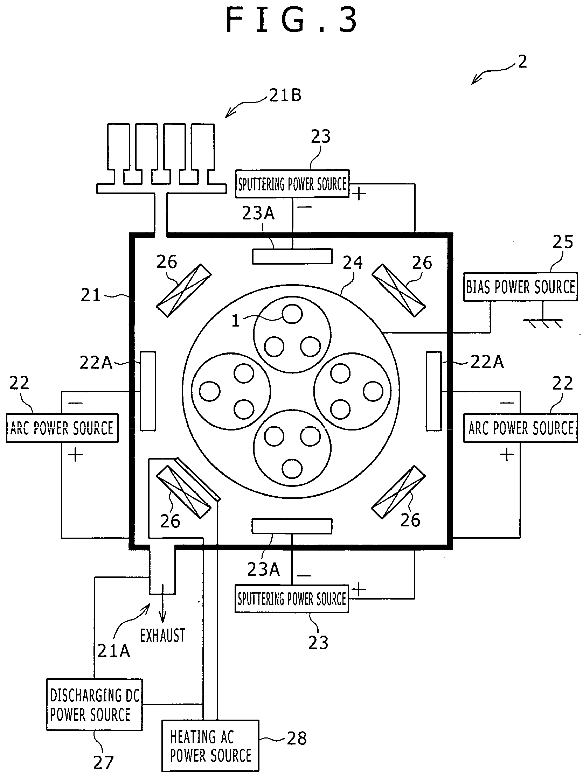

Then, a deposition process of the hard coating 12 is to be described. Fig. 3 illustrates a configuration of a deposition apparatus 2 used for coating deposition of the hard coating 12. First, the constitution of the deposition apparatus 2 is to be described with reference to Fig. 3.

The deposition apparatus 2 includes a chamber 21, arc power sources 22 and sputtering power sources 23 each in plurality (two), a stage 24, a bias power source 25, heaters 26 in plurality (four), a DC discharging power source 27, and a filament heating AC power source 28. The chamber 21 is provided with a gas exhaust port 21A for evacuation, a gas supply port 21B for supplying gas into the chamber 21. The arc power source 22 is connected with an arc evaporation source 22A on which a deposition target is disposed. The sputtering power source 23 is connected with a sputtering evaporation source 23A on which a depositing target is disposed. The stage 24 is made rotatable and has a supporting surface for supporting a material to be formed (die 1). The bias power source 25 applies a bias voltage through the stage 24 to the material to be deposited.

Then, a deposition process of the hard coating 12 over the die 1 is to be described. In this embodiment, description is to be made to an example of deposition by an arc ion plating method.

First, the die 1 is provided and set on the stage 24. On the other hand, a CrM target comprising Cr and element M mixed at a predetermined ratio is provided and set to the arc evaporation source 22A. The mixing ratio of Cr and M in the CrM target is adjusted such that the atomic ratio a of Cr in the hard coating 12 after deposition is 0.01 or more and 0.2 or less. Further, when the hard coating 12 with addition of the element M is deposited, a target further mixed with Fe, Ni, Co, Cu is provided.

Then, the inside of the chamber 21 is depressurized to a predetermined pressure by evacuation through the gas exhaust port 21A. Then, an argon (Ar) gas is introduced from a gas supply port 21B into the chamber 21 and the die 1 is heated to a predetermined temperature by the heaters 26. Then, the surface of the die 1 is etched by Ar ions for a predetermined time and oxide coatings, etc. formed on the surface of the die 1 are removed (cleaned).

Then, a hydrocarbon gas such as methane (CH₄) and Ar for pressure control are introduced from the gas supply port 21B into the chamber 21. The amount of the introduced methane gas is adjusted such that the atomic ratio b of C in the hard coating 12 after deposition is 0.03 or more and 0.5 or less. Then, a predetermined arc current is supplied from the arc power source 22 to the arc evaporation source 22A to start arc discharge thereby evaporating the CrM target set to the arc evaporation source 22A. Thus, Cr and the element M evaporated in the chamber 21 and C formed by decomposition of methane are accumulated on the surface of the die 1 to deposit the hard coating 12. In this process, the deposition speed is adjusted by the value of the arc current supplied to the arc evaporation source 22A and the deposition time is adjusted such that the thickness of the hard coating 12 reaches a desired value.

Further, when a N-added hard coating 12 is deposited, a nitrogen (N₂) gas as a nitrogen source is introduced in addition to the methane gas into the chamber 21. Then, N formed by heat decomposition of the nitrogen gas is taken into the hard coating 12. In this process, the introduction amount of the nitrogen gas is adjusted such that the atomic ratio c of N in the hard coating 12 after deposition is 0.2 or less.

Then, after the thickness of the hard coating 12 reaches a predetermined value, supply of the current from the arc power source 22 to the arc evaporation source 22A is stopped. Subsequently, the inside of the chamber 21 is opened to the atmosphere and the die 1 after deposition is taken out of the chamber 21. By the processes described above, the hard coating 12 is deposited on the die 1.

When the hard coating 12 is deposited by a sputtering method, the CrM target is set to the sputtering evaporation source 23A. Then, a predetermined amount of power is supplied from the sputtering power source 23 to the sputtering evaporation source 23A to evaporate the CrM target, by which the hard coating 12 can be deposited in the same manner as in the case of the arc ion plating described above.

### Second Embodiment

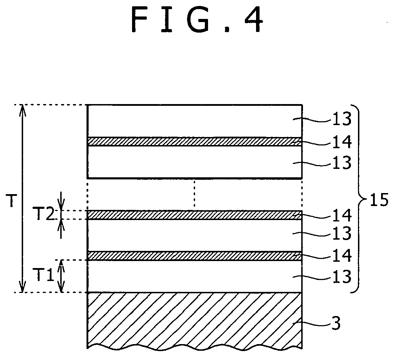

Then, a hard coating 15 according to a second embodiment of the present invention is to be described with reference to Fig. 4. The hard coating 15 according to the second embodiment contains each of the elements Cr, M and C, in which the atomic ratio of C is adjusted to 0.03 or more and 0.5 or less in the same manner as in the hard coating 12 according to the first embodiment, and the second embodiment is different in that it is a multi-layered coating comprising a first coating layer 13 and a second coating layer 14 having compositions different from each other and laminated alternately.

First, the coating composition and the coating structure of the hard coating 15 according to the second embodiment are to be described. The first coating layer 13 has a compositional formula: Cr_{1-e-f-g} MₑC_{f}N_{g}. In the compositional formula, e stands for the atomic ratio of the element M, f stands for the atomic ratio of C, and g stands for the atomic ratio of N. Since the total for the atomic ratios of the entire elements is 1, the atomic ratio of Cr is 1-e-f-g.

In the first coating layer 13, the element M comprises elements belonging to the group 4a, the group 5a, and the group 6a (except for Cr) of the periodic table, and at least one element selected from the group consisting of Al, Si and B in the same manner as in the first embodiment. In view of the improvement of the wear resistance, the element M preferably contains W, Mo, Ti, or V and particularly preferably, W and V. Further, the element M is introduced into the first coating layer 13 such that the atomic ratio e is 0 or more and 0.2 or less (0 ≤ e ≤ 0.2) and the atomic ratio e of M is less than the atomic ratio: 1-e-f-g of Cr (1-e-f-g > e). That is, the first coating layer 13 is a Cr-rich layer with addition of more Cr than the element M, and the element M may not be added (e = 0).

Further, in the first coating layer 13, C is introduced such that the atomic ratio f is 0.03 or more and 0.5 or less (0.03 ≤ f ≤ 0.5) with a view point of improving the wear resistance of the coating in the same manner as in the first embodiment. Further, N is introduced into the first coating layer 13 such that the atomic ratio g is 0 or more and 0.2 or less so that the amount of carbides in the coating is not decreased excessively as in the case of the first embodiment (0 ≤ g ≤ 0.2). That is, N may not be added to the first coating layer 13 (g = 0).

The second coating layer 14 has a compositional formula: M₁₋ₕ₋ᵢ₋ⱼ₋ₖ CrₕCᵢNⱼXₖ. In the compositional formula, h stands for the atomic ratio of Cr, i stands for the atomic ratio of C, j stands for the atomic ratio N, and k stands for the atomic ratio of the element X, and the atomic ratio of the element M is represented by 1-h-i-j-k.

In the second coating layer 14, the element M is identical with that added to the first coating layer 13. Further, the element M is introduced into the second coating layer 14 such that the atomic ratio: 1-h-i-j-k is greater than the atomic ratio h of Cr (1-h-i-j-k > h). That is, the second coating layer 14 is an element M-rich layer in which the element M is added more than Cr contrary to the first coating layer 13. Further, Cr is introduced into the second coating layer 14 such that the atomic ratio h is 0 or more and 0.2 or less (0 ≤ h ≤ 0.2). That is, in the second coating layer 14, Cr may not be added (h = 0).

Further, in the second coating layer 14, C is introduced such that the atomic ratio i is 0.03 or more and 0.5 or less with a view point of improving the wear resistance of the coating in the same manner as in the first embodiment described above (0.03 ≤ i ≤ 0.5). Further, N is introduced into the second coating layer 14 such that the atomic ratio j is 0 or more and 0.2 or less so as not to excessively decrease the amount of carbides in the coating in the same manner as in the first embodiment (0 ≤ j ≤ 0.2). That is, N may not be added to the second coating layer 14 (j = 0).

The element X is at least one element selected from the group consisting of Fe, Ni, Co, and Cu in the same manner as in the first embodiment and is introduced such that the atomic ratio k is 0.05 or less (preferably, 0.03 or less, more preferably, 0.01 or less) in the second coating layer 14. This improves the wear resistance of the coating and suppresses deterioration of the wear resistance by excess addition of the element X.

As described above, the hard coating 15 according to the second embodiment comprises a multi-layered coating formed by alternately laminating a first coating layer 13 with addition of more Cr than the element M and a second coating layer 14 with addition of more element M than Cr thereby improving the wear resistance by introducing the predetermined element M and by defining each of the atomic ratios f and i of C in each of the layers to 0.03 or more and 0.5 or less in the same manner as in the hard coating 12 according to the first embodiment. Further, each of thicknesses T1 and T2 of first and the second coating layers 13 and 14 is preferably 100 nm or less, more preferably, 20 nm or less and, further preferably, 10 nm or less with a view point of sufficiently obtaining the effect as the multi-layered coating. The number of times of laminating layers of the first and the second coating layers 13 and 14 in the hard coating 15 is set such that the entire thickness T of the hard coating 15 is about 5 µm in view of the thicknesses T1 and T2 for each of the layers. "Number of times of laminating layers" is counted as one when one first coating layer 13 and one second coating layer 14 are laminated.

The thickness T1 of the first coating layer 13 is larger than the thickness T2 of the second coating layer 14. More specifically, the thickness T1 of the first coating layer 13 is at least twice the thickness T2 of the second coating layer 14. When the thickness T1 of the Cr-rich first coating layer 13 is made larger than the thickness T2 of the element M-rich second coating layer 14, the introduction amount of the element M is not increased excessively in the entire hard coating 15 and deterioration of the wear resistance can be suppressed. On the other hand, if the thickness T1 of the first coating layer 13 is increased excessively relative to the thickness T2 of the second coating layer 14, the effect due to the second coating layer 14 (that is, the effect due to the introduction of the element M) is decreased to deteriorate the wear resistance. Accordingly, the thickness T1 of the first coating layer 13 is 10 times or less and, preferably, 5 times or less the thickness T2 of the second coating layer 14.

The first and the second coating layers 13 and 14 are not restricted to the mono-layered configuration in which each of the composition is uniform but may comprise a plurality of coating layers of different compositions. In this case, each of the plurality of coating layers constituting the first coating layer 13 has a composition different from each other within a range that satisfies the compositional formula: Cr_{1-e-f-g} MₑC_{f}N_{g} (0 ≤ e ≤ 0.2, 0.03 ≤ f ≤ 0.5, and 0 ≤ g ≤ 0.2) respectively and each of the plurality of coating layers constituting the second coating layer 14 has a composition different from each other within a range that satisfies the compositional formula: M₁₋ₕ₋ᵢ₋ⱼ₋ₖ, CrₕCᵢNⱼXₖ (0 ≤ h ≤ 0.2, 0.03 ≤ i ≤ 0.2, 0 ≤ j ≤ 0.2, and 0 ≤ k ≤ 0.05).

Further, the hard coating may comprise an alternately laminated structure of the first and the second coating layers 13 and 14 for a major part and a third coating layer of a composition different from that of the first and the second coating layers 13 and 14 in a minor portion along the direction of the thickness thereof. Also in such a coating configuration, since major portion has an alternately laminated structure of the first and the second coating layers 13 and 14, an effect of improving the wear resistance can also be obtained in the same manner as in the hard coating 15 illustrated in Fig. 4.

Then, the deposition process of the hard coating 15 according to the second embodiment is to be described. First, the die 1 is set on the stage 24 in the same manner as in the first embodiment. Then, a first target for depositing the first coating layer 13 and a second target for depositing the second coating layer 14 are provided and they are set to separate arc evaporation sources 22A respectively. In the first target, Cr and M are adjusted each to predetermined mixing ratios (or Cr is used alone) so as to satisfy the composition of the first coating layer 13 described above and, in the second target, M and Cr are adjusted each to predetermined mixing ratios (or M is used alone) so as to satisfy the composition of the second coating layer 14. Further, in a case of depositing a second coating layer 14 with addition of the element X, a second target formed by further mixing Fe, Ni, Co or Cu is provided.

Then, in the same manner as in the first embodiment, inside of the chamber 21 is depressurized, the die 1 is heated, the surface of the die 1 is cleaned, and the methane gas and the nitrogen gas are introduced into the chamber 21 successively. Then, an arc current is supplied to each of the arc evaporation sources 22A with attachment of the first and the second targets thereby evaporating the first and the second targets, and the stage 24 is rotated concurrently. Thus, since the die 1 alternately passes over the arc evaporation sources 22A to which the first and the second targets are set, the first coating layer 13 and the second coating layer 14 are laminated alternately over the die 1. In this process, each of the thicknesses T1 and T2 of the first and the second coating layers 13 and 14 can be controlled by adjusting the deposition rate depending on the value of current supplied to the arc evaporation sources 22A. With the processes described above, a hard coating 15 formed by alternately laminating the first and the second coating layers 13, 14 are deposited over the die 1.

### Example

For confirming the advantageous effect of the invention on the wear resistance of the hard coating, the following experiments were performed.

### Example 1

First, a hard coating having an atomic ratio of No. 4 in the following Table 1 was prepared by the following procedures using the deposition apparatus 2 illustrated in Fig. 3. First, a ball (10 mm in diameter) according to JIS Standards SKD11 (Rockwell hardness (HRC): 60) was provided as a substrate of sliding test for evaluating the wear resistance of the coating and set on the stage 24 in the chamber 21. Further, a CrW target having an atomic ratio of No. 4 in the following Table 1 was set to an AIP evaporation source 22A.

Then, the inside of the chamber 21 was depressurized to about 1 x 10⁻³ Pa. Then, an Ar gas was introduced into the chamber 21 and, after heating the substrate to 450°C, the surface of the substrate was etched for 5 min by Ar ions (cleaned).

Then, Ar and a methane gas were introduced till the pressure in the chamber 21 reached 2.7 Pa. Then, an arc current at 150 A was supplied to initiate arc discharge and a voltage at 50 V was applied to the substrate, thereby depositing the hard coating over the substrate. The deposition time was adjusted such that the thickness of the hard coating was about 5 µm.

Further, hard coatings having atomic ratios of Nos. 3 and 5 to 38 were prepared by the same procedures in the same manner as in the sample No. 4. A hard coating with no addition of C (No. 3) was deposited by arc discharge in an Ar atmosphere without introducing the methane gas. Further, hard coatings with addition of N (Nos. 18 to 21) were deposited by arc discharge by introducing a gas mixture of a methane gas and a nitrogen gas in an Ar-CH₄-N₂ atmosphere. Further, hard coatings with addition of the element X (Nos. 32 to 38) were deposited by using targets formed by further mixing Fe, Ni, Co, or Cu in addition to Cr and W. Further, as a comparative example, coatings of CrC (No. 1) and TiAlN (No. 2) were also prepared.

In addition to the balls for the sliding test, test specimens of super-hard alloy (JIS-P type, 12 x 12 x 4.7 mm, mirror polished on one surface) as a substrate for hardness measurement and steel test specimen as a substrate for composition analysis (JIS-SKD11, 40 x 40 x 10 mm, mirror polished) were also prepared and coating deposition was performed also to such substrates.

Compositions of the coatings were analyzed using samples of steel test specimens, by measuring each of the atomic ratios by quantitative analysis with EDX (S-3500 NSEM, manufactured by Hitachi, Ltd., EDX measuring conditions, including acceleration voltage of 20 kV, WD of 15 mm, magnification factor of 1000X, for three portions in average). The hardness was measured by using samples of super-hard alloy test specimens, indenting a diamond pressor under the conditions at a load of 0.25 N and a holding time of 15 sec. and measuring the Vickers hardness (HV). The vibration test was performed by sliding movement of a SKD ball after deposition and a hot-dip galvannealed (GA) steel sheet (galvanized steel sheet) and measuring the area of a worn portion formed to a portion of the ball in contact with the steel sheet. The sliding test was carried out under the conditions of a vertical load of 5 N, a sliding velocity of 0.1 m/s, sliding width of 30 mm (reciprocal), and the worn area of balls (mm²) was measured after the sliding distance reached 600 m. The test results are shown in Table 1.

**[Table 1]**

| No. | | Atomic ratio of Cr | Kind of M | Atomic ratio of M | Atomic ratio of C | Atomic ratio of N | Co, Ni, Fe, Cu | Atomic ratios of Co, Ni, Fe and Cu | Hardness (HV) | Worn area (mm²) | Adhesion test |
|---|---|---|---|---|---|---|---|---|---|---|---|
| 1 | Comp. Example | CrC | | | | | - | 0 | 1500 | 2.2 | 5 |
| 2 | Comp. Example | TiAlN | | | | | - | 0 | 2700 | 2 | 5 |
| 3 | Comp. Example | 0.9 | W | 0.1 | 0 | 0 | - | 0 | 900 | 2.5 | 5 |
| 4 | Example | 0.87 | W | 0.1 | 0.03 | 0 | - | 0 | 2400 | 0.5 | 2 |
| 5 | Comp. Example | 0.89 | W | 0.1 | 0.01 | 0 | - | 0 | 1100 | 2.2 | 4 |
| 6 | Example | 0.85 | W | 0.1 | 0.05 | 0 | - | 0 | 2500 | 0.3 | 0 |
| 7 | Example | 0.8 | W | 0.1 | 0.1 | 0 | - | 0 | 2500 | 0.3 | 0 |
| 8 | Example | 0.75 | W | 0.1 | 0.15 | 0 | - | 0 | 2400 | 0.3 | 0 |
| 9 | Example | 0.7 | W | 0.1 | 0.2 | 0 | - | 0 | 2400 | 0.35 | 0 |
| 10 | Example | 0.65 | W | 0.1 | 0.25 | 0 | - | 0 | 2400 | 0.4 | 0 |
| 11 | Example | 0.45 | W | 0.1 | 0.45 | 0 | - | 0 | 2300 | 0.6 | 0 |
| 12 | Example | 0.4 | W | 0.1 | 0.5 | 0 | - | 0 | 2200 | 0.8 | 0 |
| 13 | Comp. Example | 0.2 | W | 0.1 | 0.7 | 0 | - | 0 | 1500 | 1.7 | 0 |
| 14 | Example | 0.845 | W | 0.005 | 0.15 | 0 | - | 0 | 1400 | 1.6 | 0 |
| 15 | Example | 0.8 | W | 0.05 | 0.15 | 0 | - | 0 | 2300 | 0.4 | 0 |
| 16 | Example | 0.65 | W | 0.2 | 0.15 | 0 | - | 0 | 2300 | 0.8 | 2 |
| 17 | Example | 0.55 | W | 0.3 | 0.15 | 0 | - | 0 | 1400 | 1.7 | 3 |
| 18 | Example | 0.7 | W | 0.05 | 0.2 | 0.05 | - | 0 | 2300 | 0.5 | 0 |
| 19 | Example | 0.65 | W | 0.05 | 0.2 | 0.1 | - | 0 | 2400 | 0.4 | 0 |
| 20 | Example | 0.55 | W | 0.05 | 0.2 | 0.2 | - | 0 | 2300 | 0.5 | 0 |
| 21 | Example | 0.5 | W | 0.05 | 0.2 | 0.25 | - | 0 | 1500 | 1.8 | 0 |
| 22 | Example | 0.72 | V | 0.1 | 0.18 | 0 | - | 0 | 2500 | 0.3 | 0 |
| 23 | Example | 0.72 | Ti | 0.1 | 0.18 | 0 | - | 0 | 2200 | 0.6 | 1 |
| 24 | Example | 0.72 | Zr | 0.1 | 0.18 | 0 | - | 9 | 2200 | 0.6 | 1 |
| 25 | Example | 0.72 | Hf | 0.1 | 0.18 | 0 | - | 0 | 2200 | 0.6 | 1 |
| 26 | Example | 0.72 | Nb | 0.1 | 0.18 | 0 | - | 0 | 2300 | 0.5 | 1 |
| 27 | Example | 0.72 | Ta | 0.1 | 0.18 | 0 | - | 0 | 2100 | 0.6 | 1 |
| 28 | Example | 0.72 | Mo | 0.1 | 0.18 | 0 | - | 0 | 2100 | 0.6 | 1 |
| 29 | Example | 0.72 | Al | 0.1 | 0.18 | 0 | - | 0 | 1800 | 0.8 | 1 |
| 30 | Example | 0.72 | Si | 0.1 | 0.18 | 0 | - | 0 | 1800 | 0.8 | 1 |
| 31 | Example | 0.72 | B | 0.1 | 0.18 | 0 | - | 0 | 1900 | 1.1 | 1 |
| 32 | Example | 0.6 | W | 0.1 | 0.2 | 0 | Co | 0.1 | 1700 | 1.5 | 4 |
| 33 | Example | 0.65 | W | 0.1 | 0.2 | 0 | Co | 0.05 | 2200 | 0.8 | 2 |
| 34 | Example | 0.67 | W | 0.1 | 0.2 | 0 | Co | 0.03 | 2300 | 0.4 | 0 |
| 35 | Example | 0.69 | W | 0.1 | 0.2 | 0 | Co | 0.01 | 2500 | 0.25 | 0 |
| 36 | Example | 0.69 | W | 0.1 | 0.2 | 0 | Cu | 0.01 | 2400 | 0.3 | 0 |
| 37 | Example | 0.69 | W | 0.1 | 0.2 | 0 | Ni | 0.01 | 2400 | 0.32 | 0 |
| 38 | Example | 0.69 | W | 0.1 | 0.2 | 0 | Fe | 0.01 | 2300 | 0.35 | 0 |

First, in samples containing the element M and having an atomic ratio of C of 0.03 or more and 0.5 or less (Nos. 4, 6 to 12, and 14 to 38), the worn area was generally decreased compared with samples not containing the element M (Nos. 1 and 2) and samples having the atomic ratio of C out of the range of 0.03 or more and 0.5 or less (Nos. 3, 5 and 13). Further, in samples Nos. 14 to 17, worn area was decreased for samples having an atomic ratio of M within the range of 0.01 or more and 0.2 or less (Nos. 15 and 16) compared with those having the atomic ratio out of such a range (Nos. 14 and 17). Further, in samples Nos. 18 to 21, the worn area was decreased for samples having the atomic ratio of N within the range of 0.2 or less (Nos. 18 to 20) compared with those having the atomic ratio of N out of such a range (No. 21). Further, in samples Nos. 22 to 31, when V is selected as the element M (No. 22), the worn area was decreased compared with the case of selecting other elements (Nos. 23 to 31). Further, in samples Nos. 32 to 38, the worn area was decreased for samples having the atomic ratio of the element X (Co, Ni, Fe, Cu) within the range of 0.05 or less (Nos. 33 to 38), compared with those having the atomic ratio out of such a range (No. 32). The adhesion test is to be described later.

### Example 2

Then, a hard coating having atomic ratio No. 1 in the following Table 2 was prepared. First, a Cr target having an atomic ratio of the first coating layer and a target of element M (W) having an atomic ratio of the second coating layer of No. 1 were set to the separate AIP evaporation sources 22A or the sputtering evaporation sources 23A respectively. Then, each thickness of the first and the second coating layers was adjusted by the deposition rate (arc current or sputtering power) in each of the evaporation sources 22A, 23A and the number of rotation of the stage 24 during deposition. Thus, a hard coating prepared by alternately laminating the first and the second coating layers having compositions different from each other was deposited. Other deposition conditions and coating test methods were made identical with those of Example 1.

In the same manner as in the No. 1 sample, hard coatings having atomic ratios of Nos. 2 to 22 were prepared by the same procedures. During deposition of hard coatings with addition of N (Nos. 8 and 9), a gas mixture of a methane gas and a nitrogen gas was introduced into the chamber 21. Further, targets for the first coating layers formed by mixing Cr and W at predetermined ratios were prepared for Nos. 12 to 15, and targets for the second coating layers formed by mixing Cr and Mo at a predetermined ratio were prepared in Nos. 16 and 17. Further, targets for the second coating layers formed by mixing W and the element X (Fe, Ni, Co, Cu) at predetermined ratios were prepared for Nos. 18 to 22. Table 2 shows the result of test. In Table 2, each of the atomic ratios in the first and the second coating layers is expressed, for example, as "Cr0.85 C0.15" in a case where the atomic ratio of Cr is 0.85 and the atomic ratio of C is 0.15.

**[Table 2]**

| No. | | First coating layer | Thickness (nm) | Second coating layer | Thickness (nm) | Worn area (mm²) | Adhesion test |
|---|---|---|---|---|---|---|---|
| 1 | Example | Cr0.85C0.15 | 100 | W0.5C0.5 | 5 | 0.8 | 0 |
| 2 | Example | Cr0.85C0.15 | 50 | W0.5C0.5 | 5 | 0.5 | 0 |
| 3 | Example | Cr0.85C0.15 | 25 | W0.5C0.5 | 5 | 0.3 | 0 |
| 4 | Example | Cr0.85C0.15 | 10 | W0.5C0.5 | 5 | 0.4 | 0 |
| 5 | Example | Cr0.85C0.15 | 5 | W0.5C0.5 | 5 | 0.6 | 0 |
| 6 | Example | Cr0.85C0.15 | 2 | W0.5C0.5 | 5 | 0.9 | 2 |
| 7 | Example | Cr0.85C0.15 | 25 | V0.5C0.5 | 2 | 0.3 | 0 |
| 8 | Example | Cr0.8C0.1 N0.1 | 8 | V0.7C0.2N0.1 | 2 | 0.7 | 0 |
| 9 | Example | Cr0.8C0.1N0.1 | 8 | Nb0.7C0.2N0.1 | 2 | 0.7 | 0 |
| 10 | Example | Cr0.9C0.1 | 8 | Ta0.8C0.2 | 2 | 0.6 | 0 |
| 11 | Example | Cr0.9C0.1 | 8 | Mo0.8C0.2 | 2 | 0.8 | 0 |
| 12 | Example | Cr0.9W0.01C0.09 | 10 | W0.5C0.5 | 3 | 0.5 | 0 |
| 13 | Example | Cr0.65W0.2C0.15 | 10 | W0.5C0.5 | 3 | 0.7 | 0 |
| 14 | Example | Cr0.45W0.4C0.15 | 10 | W0.5C0.5 | 3 | 0.9 | 2 |
| 15 | Example | Cr0.3W0.6C0.1 | 10 | W0.5C0.5 | 3 | 1.8 | 2 |
| 16 | Example | Cr0.9C0.1 | 8 | Cr0.1Mo0.7C0.2 | 2 | 0.8 | 2 |
| 17 | Example | Cr0.9C0.1 | 8 | Cr0.45Mo0.35C0.2 | 2 | 1.6 | 2 |
| 18 | Example | Cr0.85C0.15 | 25 | W0.47C0.5Co0.03 | 5 | 0.25 | 0 |
| 19 | Example | Cr0.85C0.15 | 25 | W0.49C0.5Co0.01 | 5 | 0.27 | 0 |
| 20 | Example | Cr0.85C0.15 | 25 | W0.47C0.5Fe0.03 | 5 | 0.3 | 0 |
| 21 | Example | Cr0.85C0.15 | 25 | W0.47C0.5Ni0.03 | 5 | 0.3 | 0 |
| 22 | Example | Cr0.85C0.15 | 25 | W0.47C0.5Cu0.03 | 5 | 0.3 | 0 |

Any of samples Nos. 1 to 22 contains the element M and has the atomic ratio of C within a range of 0.03 or more and 0.5 or less, and the worn area was generally decreased compared with samples not containing the element M (Nos. 1 and 2 in Table 1) and samples having an atomic ratio of C out of the range of 0.03 or more and 0.5 or less (Nos. 3, 5 and 13 in Table 1). Further, in samples Nos. 1 to 7, the worn area was decreased in a case where the thickness of the first coating layer is smaller than the thickness of the second coating layer (No. 6) for the samples where the thickness of the first coating layer is larger than the thickness of the second coating layer (Nos. 1 to 5 and 7). Further, in samples Nos. 12 to 15, when the atomic ratio of Cr is larger than the atomic ratio of W in the first coating layer (Nos. 12 to 14), the worn area was decreased compared with a case where the atomic ratio of Cr is smaller than the atomic ratio of W (No. 15). Further, in the samples Nos. 16 and 17, when the atomic ratio of Mo in the second coating layer is larger than the atomic ratio of Cr (No. 16), the worn area was decreased, compared with the case where the atomic ratio of Mo is smaller than the atomic ratio of Cr (No. 17).

### Example 3

The hard coatings having the atomic ratios shown in Tables 1 and 2 were deposited to a bending die (R10, JIS-SKD61). Further, as a sheet material (blank), a hot-dip galvannealed (GA) steel sheet (galvanized steel sheet) was prepared. Then, the galvanized steel sheet heated by using the die after deposition was subjected to bending fabrication, and the adhesion state of zinc on the surface of the die after fabrication was confirmed. The forming conditions and the evaluation standards of the adhesion property were as shown below. Tables 1 and 2 show the result of evaluation for the adhesion property.

### Forming Condition

Sheet material (blank): Hot-dip galvannealed (GA) steel sheet (tensile strength 590 MPa, sheet thickness 1.4 mm)
Die: JIS Standards SKD61 material
Pressing load: 1 t
Sheet material heating temperature: 760°C

### Evaluation criteria for adhesion

The ratio (%) of an area where zinc was adhered on the surface of the die in contact with the sheet material was calculated and evaluated by the following ranks 0 to 5.
- 5:: More than 60%
- 4:: More than 30% and 60% or less
- 3:: More than 20% and 30% or less
- 2:: More than 10% and 20% or less
- 1:: More than 0% and 10% or less
- 0:: Scarcely adhered

As illustrated in Tables 1 and 2, the adhesion amount was larger in the samples Nos. 1 and 2 with no addition of the element M, and samples Nos. 3 and 5 where the atomic ratio of C is less than 0.03. However, compared with them, the adhesion amount was generally decreased in other samples. Further, the adhesion amount was decreased in a case where the atomic ratio of the element M was 0.2 or less compared with the case where the atomic ratio of the element M is more than 0.2 in Table 1.

It should be considered that the preferred embodiments and examples disclosed herein are examples but not restrictive in every respects. The range of the present invention is shown by the scope of the claim for patent but not by the explanation described above and it intends to incorporate all modifications within the equivalent meaning and range in the scope of claim for patent.

## Claims

1. A hard coating at least containing each of elements Cr, M and C, wherein
the element M comprises elements belonging to the group 4a of the periodic table, elements belonging to the group 5a of the periodic table, elements belonging to the group 6a of the periodic table except for Cr, and at least one of elements selected from the group consisting of Al, Si and B, and
the atomic ratio of C in the hard coating is 0.03 or more and 0.5 or less.

2. The hard coating according to claim 1, comprising
a mono-layered coating having a compositional formula: Cr_{1-a-b-c-d} MₐC_{b}N_{c}X_{d}, wherein
the element X is at least one element selected from the group consisting of Fe, Ni, Co, and Cu, and
in the compositional formula, a, b, c, and d each represent the atomic ratio of M, C, N, and X respectively, where relations: 0.01 ≤ a ≤ 0.2 and 0.03 ≤ b ≤ 0.5 are satisfied.

3. The hard coating according to claim 2, wherein the relation: 0 ≤ c ≤ 0.2 is satisfied.

4. The hard coating according to claim 2 or 3, wherein the relation: 0 ≤ d ≤ 0.05 is satisfied.

5. The hard coating according to claim 1 comprising a multi-layered coating formed by alternately laminating a first coating layer and a second coating layer, wherein
the first coating layer has a compositional formula: Cr_{1-e-f-g} MₑC_{f}N_{g}, e, f, g in the compositional formula each represent the atomic ratio of M, C and N respectively,
relations 0.03 ≤ f ≤ 0.5 and 1-e-f-g > e are satisfied,
the second coating layer has a compositional formula: M₁₋ₕ₋ᵢ₋ⱼ₋ₖ CrₕCᵢNⱼXₖ,
the element X is at least one element selected from the group consisting of Fe, Ni, Co and Cu, and
h, i, j, k each represent the atomic ratios of Cr, C, N and X respectively in the compositional formula of the second coating layer, and satisfy the relations: 0.03 ≤ i ≤ 0.5 and 1-h-i-j-k > h.

6. The hard coating according to claim 5, wherein
the first coating layer satisfies the relation: 0 ≤ g ≤ 0.2, and
the second coating layer satisfies the relation: 0 ≤ j ≤ 0.2.

7. The hard coating according to claim 5 or 6, wherein the relation: 0 ≤ k ≤ 0.05 is satisfied.

8. The hard coating according to any one of claims 5 to 7, wherein
the thickness of the first coating layer is larger than the thickness of the second coating layer.

9. The hard coating according to any one of claims 1 to 8, wherein
the element M is at least one element selected from W and V.

10. A die having a forming surface for forming a material to be formed, wherein
the hard coating according to any one of claims 1 to 9 is formed on the forming surface.

11. The die according to claim 10 for forming a material to be formed in which a metal layer containing Al or Zn is formed on the surface.
